# FASCICULE DE BREVET EUROPEEN

(11) **EP 2 154 635 B1**
(45) Date de publication et mention de la délivrance du brevet: **21.09.2011**
(21) Numéro de dépôt: 09166481.3
(22) Date de dépôt: 27.07.2009
(51) Int. Cl.: G06K 19/073

(54) **Dispositif de détection d'une attaque d'un circuit intégré**
Vorrichtung zur Erkennung eines Angriffs auf einen Schaltungschip
Apparatus for detection of attacks on a circuit chip

(30) Priorité: 13.08.2008 FR 0855552
(43) Date de publication de la demande: 17.02.2010
(73) Titulaire: STMicroelectronics (Rousset) SAS, 13790 Rousset (FR)
(72) Inventeur: Fornara, Pascal, 83910, POURRIERES (FR); Rivero, Christian, 13080, LUYNES (FR)
(74) Mandataire: de Beaumont, Michel

(56) Documents cités:
- FR-A- 2 801 999
- US-A- 5 761 054

## Description

### Domaine de l'invention

La présente invention concerne un dispositif pour détecter les attaques par prise de contact d'un circuit intégré. Ce type d'attaque est généralement appelé "attaque par intrusion" et consiste à appliquer des pointes conductrices directement sur des zones du circuit intégré pour en prélever des signaux. Dans un circuit intégré, les couches actives contiennent des circuits de traitement d'informations qui peuvent être confidentielles comme par exemple dans les puces des cartes de crédit ou les puces de contrôle d'accès dans les applications de télévision à péage.

### Exposé de l'art antérieur

Pour protéger les circuits situés dans la zone active de toute intrusion frauduleuse, il est connu d'utiliser un écran couvrant toute la surface du circuit ou une partie de celle-ci. Cet écran est généralement constitué d'un ou de plusieurs chemins conducteurs formés dans un ou plusieurs niveaux de métallisation supérieurs à la zone active à protéger, comme décrit dans le document FR-A-2 801 999. Le but de ces chemins conducteurs est de détecter une rupture de continuité ou toute modification électrique de leurs propriétés, par exemple résistance et capacité. Ces chemins conducteurs parcourent toute la surface ou seulement une zone du circuit à protéger de façon irrégulière et aléatoire. Si un "pirate" tente de traverser le niveau de métallisation contenant le chemin, par introduction d'une ou de plusieurs pointes, un circuit de détection est censé détecter une rupture du chemin conducteur.

Un inconvénient d'une telle solution est qu'elle ne permet pas de détecter le retrait des couches isolantes recouvrant le chemin conducteur. Une fois que le chemin conducteur est exposé, un "pirate" pourrait doubler ce chemin conducteur par un tronçon extérieur afin de simuler une continuité électrique. Le chemin conducteur pourrait alors être interrompu sans que cela ne soit détecté.

### Résumé

L'invention vise à améliorer la détection d'attaques par intrusion sur un circuit intégré en permettant la détection du retrait de couches isolantes recouvrant le circuit intégré.

Ainsi, un mode de réalisation de la présente invention prévoit un circuit intégré comprenant un dispositif de détection d'attaque par intrusion, selon la revendication 1.

Selon un exemple de réalisation de l'invention, la pièce monobloc comprend une première barre s'étendant selon une première direction, une deuxième barre s'étendant selon une deuxième direction inclinée par rapport à la première direction et reliée à une première face latérale de la première barre au niveau d'une première zone de jonction et une troisième barre s'étendant selon une troisième direction inclinée par rapport à la première direction et reliée à une seconde face latérale de la première barre, opposée à la première face latérale, au niveau d'une seconde zone de jonction, les première et seconde zones de jonction étant décalées selon la première direction. La au moins une portion conductrice est à distance des première, deuxième et troisième barres et disposée en vis-à-vis de la première ou seconde face latérale. Il en résulte une variation de la longueur des deuxième et troisième barres lors de l'attaque par retrait du matériau isolant, entraînant un pivotement de la première barre jusqu'à venir au contact de la portion conductrice.

Selon un exemple de réalisation de l'invention, la première barre comprend des première et seconde extrémités. La portion conductrice est disposée en vis-à-vis de la première face latérale, au niveau de la première extrémité, le circuit comprenant une portion conductrice supplémentaire disposée en vis-à-vis de la seconde face latérale, à distance des première, deuxième et troisième barres, au niveau de la seconde extrémité. Il en résulte une variation de la longueur des deuxième et troisième barres lors de l'attaque par retrait du matériau isolant, entraînant un pivotement de la première barre de façon que la première extrémité vienne en contact avec la portion conductrice et que la seconde extrémité vienne en contact avec la portion conductrice supplémentaire.

Selon un exemple de réalisation de l'invention, la deuxième barre se prolonge par une première piste du matériau conducteur de section plus importante et la troisième barre se prolonge par une seconde piste du matériau conducteur de section plus importante.

Selon un exemple de réalisation de l'invention, les deuxième et troisième barres appartiennent à un chemin conducteur.

Selon un exemple de réalisation de l'invention, la section de la deuxième barre diminue au niveau de la première zone de jonction et la section de la troisième barre diminue au niveau de la seconde zone de jonction.

Selon un exemple de réalisation de l'invention, la première barre comprend une face biseautée adaptée à venir en appui contre la portion conductrice lors du pivotement de la première barre.

Selon un exemple de réalisation de l'invention, les deuxième et troisième directions sont parallèles entre elles et perpendiculaires à la première direction.

Un exemple de réalisation de la présente invention prévoit également un procédé de fabrication d'un circuit intégré comprenant un dispositif de détection d'attaque par intrusion, selon la revendication 9.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est destinée à exposer l'état de la technique ;
la figure 2 est une vue de dessus schématique d'un dispositif de détection d'attaques par prise de contact d'un circuit intégré selon un exemple de réalisation de l'invention ;
la figure 3 est une section schématique du dispositif de détection de la figure 2 ;
la figure 4 est une section analogue à la figure 3 illustrant le principe d'une attaque par prise de contact ;
la figure 5 est une vue analogue à la figure 2 illustrant le fonctionnement du dispositif de détection selon le présent exemple de réalisation de l'invention lors d'une attaque par prise de contact ;
la figure 6 représente l'évolution d'un paramètre de fonctionnement du dispositif de détection de la figure 2 en fonction d'une dimension caractéristique du dispositif de détection ; et
les figures 7 et 8 sont des vues de dessus de détail de dispositifs de détection selon d'autres exemples de réalisation de l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Dans la suite de la description, on considère un circuit intégré comprenant un substrat (par exemple un substrat semiconducteur massif, un substrat du type silicium sur isolant (SOI), etc.) recouvert d'un empilement de couches d'un matériau isolant au niveau desquelles sont prévues des pistes métalliques de différents niveaux de métallisation. Les pistes métalliques d'un niveau de métallisation donné peuvent être disposées sur la surface d'une couche isolante ou formées dans une couche isolante et affleurant à la surface de celle-ci. On appelle pistes métalliques du dernier niveau de métallisation, ou niveau de métallisation supérieur, les pistes métalliques les plus éloignées du substrat. Les pistes métalliques du dernier niveau de métallisation sont recouvertes d'une couche isolante, généralement appelée couche de passivation.

Selon un exemple de réalisation de la présente invention, un dispositif de détection du retrait d'une couche isolante recouvrant des pistes métalliques d'un niveau de métallisation donné est constitué, au moins en partie, par des pistes métalliques du niveau de métallisation donné. De façon avantageuse, selon un exemple de réalisation de l'invention, les pistes métalliques formant le dispositif de détection peuvent également appartenir à un chemin conducteur d'un écran de protection. Un exemple de réalisation de l'invention est basé sur le fait qu'un procédé classique de fabrication d'un circuit intégré entraîne l'apparition de contraintes de tension dans les pistes métalliques des différents niveaux de métallisation. Ceci est dû au fait qu'un recuit est généralement effectué une fois que les pistes métalliques et les couches isolantes sont formées. Le recuit entraîne une croissance des grains des pistes métalliques et une diminution de la densité de joints de grain. Il en résulte l'apparition de contraintes de tension dans les pistes métalliques étant donné que le matériau isolant qui les entoure les contraint à conserver leur forme. Le retrait du matériau isolant entourant les pistes métalliques entraîne une libération des contraintes dans ces pistes. Un exemple de réalisation de l'invention prévoit un dispositif de détection du retrait du matériau isolant lors d'une attaque par intrusion. Le dispositif comprend un interrupteur mécanique comportant une pièce mobile qui est déplacée lors de la libération des contraintes pour établir un contact électrique. L'établissement du contact électrique est détecté et est représentatif du retrait du matériau isolant.

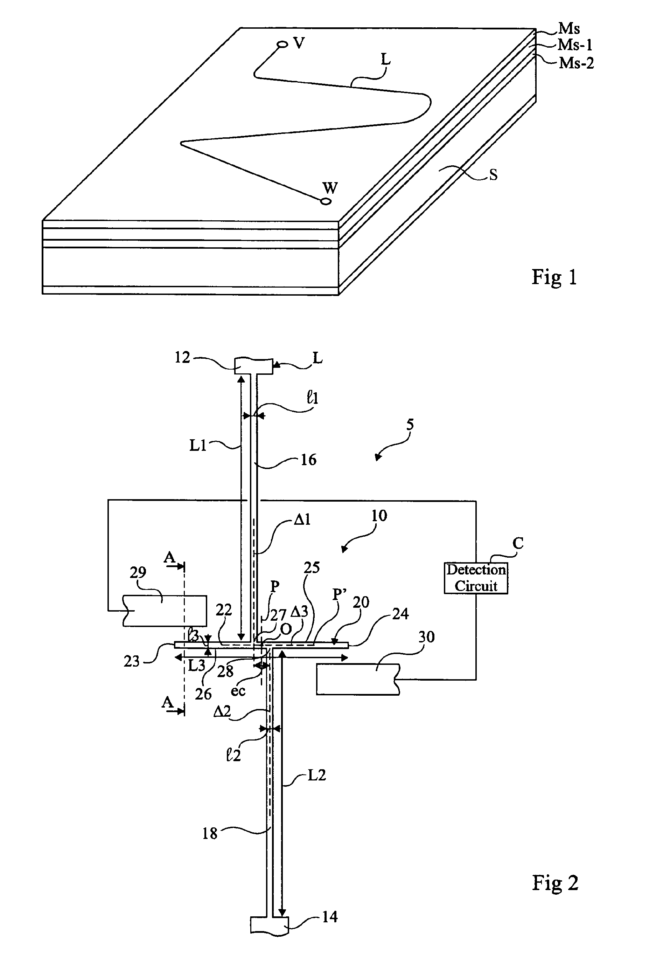

La figure 1 est une vue en perspective d'un circuit intégré muni, de façon classique, d'un écran de protection. Le circuit comprend un substrat S recouvert d'un empilement de couches isolantes auxquelles sont associés différents niveaux de métallisation M1...Ms. Un chemin conducteur L délimité par les bornes V et W est formé dans un de ces niveaux, par exemple le niveau de métallisation supérieur Ms. Le chemin conducteur L est connecté à ses extrémités à un circuit, non représenté, adapté à détecter une interruption du chemin conducteur L.

La figure 2 représente un dispositif de détection 5 selon un exemple de réalisation de l'invention. Le dispositif 5 comprend un interrupteur mécanique 10 relié à un circuit de détection C (Detection Circuit). Plus précisément, la figure 2 est une vue de dessus partielle et schématique de pistes métalliques d'un même niveau de métallisation d'un circuit intégré formant l'interrupteur 10 selon un exemple de réalisation de l'invention, le circuit de détection C étant représenté de façon schématique par un bloc. L'interrupteur 10 peut être dupliqué en plusieurs emplacements au niveau d'un même niveau de métallisation. Il peut, en outre, être dupliqué en plusieurs emplacements dans différents niveaux de métallisation d'un même circuit intégré.

L'interrupteur 10 est réalisé au niveau d'un chemin conducteur L comprenant des première et seconde pistes métalliques 12, 14. Il comprend un bras 16 correspondant à une piste métallique de longueur L1, de largeur ℓ1 et s'étendant selon un axe central rectiligne Δ1. Le bras 16 prolonge la piste 12 et a une section inférieure à la section de la piste 12. L'interrupteur 10 comprend, en outre, un bras 18 correspondant à une piste métallique de longueur L2, de largeur ℓ2 et s'étendant selon un axe central rectiligne Δ2. Le bras 18 prolonge la piste 14 et a une section inférieure à la section de la piste 14. Les axes Δ1 et Δ2 sont, par exemple, parallèles. Dans le présent exemple de réalisation, les bras 16, 18 ont sensiblement une section constante.

L'interrupteur 10 comprend, en outre, une barre 20 correspondant à une piste métallique ayant une longueur L3, une largeur ℓ3 et s'étendant selon un axe central rectiligne Δ3 perpendiculaire aux axes Δ1 et Δ2. La barre 20 comprend une portion centrale 22 et deux extrémités libres 23, 24. La portion centrale 22 comprend deux faces latérales 25, 26 opposées. L'interrupteur 10 est symétrique par rapport à un plan de symétrie P qui correspond au plan perpendiculaire à l'axe Δ3 à équidistance des extrémités 23 et 24. On appelle O le point d'intersection entre le plan P et l'axe Δ3. On appelle P' le plan perpendiculaire aux axes Δ1 et Δ2 et contenant l'axe Δ3. A l'extrémité opposée à la piste 12, le bras 16 est relié à la face 25 de la portion centrale 22 au niveau d'une zone de jonction 27 et, à l'extrémité opposée à la piste conductrice 14, le bras 18 est relié à la face 26 de la portion centrale 22 au niveau d'une zone de jonction 28. Les bras 16, 18 sont donc disposés de part et d'autre de la barre 20. En outre, les bras 16, 18 sont situés de part et d'autre du plan P. On appelle écartement ec la distance, mesurée selon la direction Δ3, entre le milieu de la zone de jonction 27 et le milieu de la zone de jonction 28, c'est-à-dire, dans le présent exemple de réalisation, entre les axes Δ1 et Δ2.

L'interrupteur 10 comprend, en outre, des pistes métalliques 29, 30. La piste 29 est disposée du même côté de la barre 20 que le bras 16 et s'étend en vis-à-vis d'une partie de la face 25 de la portion centrale 22 à proximité de l'extrémité 23. La piste 30 est disposée du même côté de la barre 20 que le bras 18 et s'étend en vis-à-vis d'une partie de la face 26 de la portion centrale 22 du côté de l'extrémité 24. Les pistes 29 et 30 sont reliées au circuit C qui est adapté à détecter si ces pistes 29, 30 sont connectées électriquement l'une à l'autre.

Dans l'exemple de réalisation représenté en figure 2, les bras 16, 18, les pistes 12, 14 et la barre 20 sont réalisés d'une seule pièce.

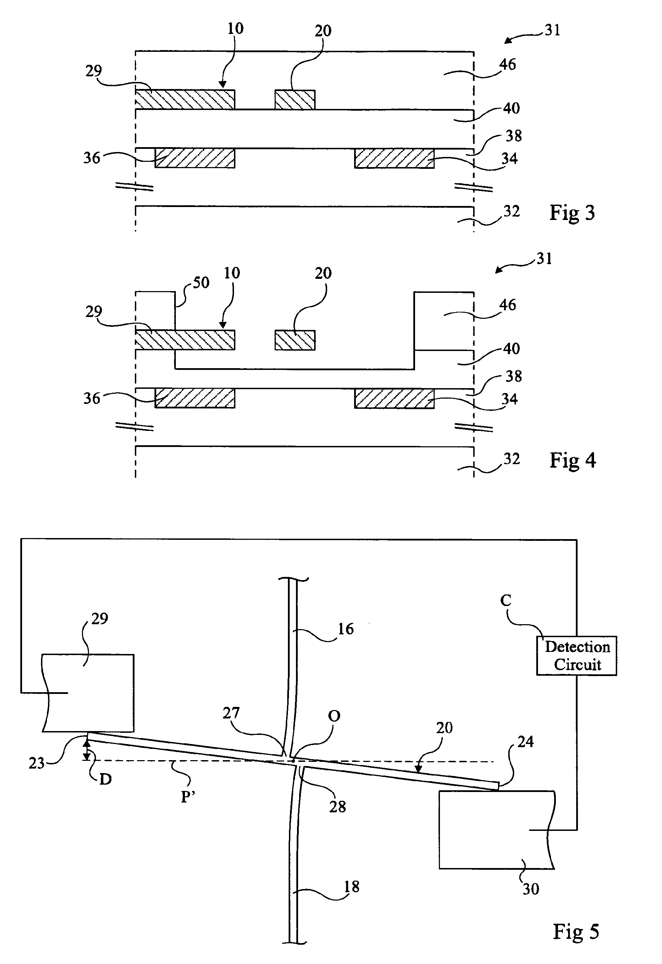

La figure 3 représente une section partielle et schématique de l'interrupteur 10 selon la ligne A-A. L'interrupteur 10 est réalisé au niveau d'un circuit intégré 31 comprenant un substrat semiconducteur 32, par exemple du silicium, recouvert d'un empilement de couches isolantes au niveau desquelles sont disposées des pistes métalliques de différents niveaux de métallisation. A titre d'exemple, on a représenté des pistes métalliques 34, 36 du niveau de métallisation Ms-1 affleurant à la surface d'une couche isolante 38. On a, en outre, représenté une couche isolante 40 recouvrant la couche isolante 38 et les pistes métalliques 36 et 34. Les pistes métalliques du niveau de métallisation Ms 20, 29 s'étendent sur la couche isolante 40. A titre d'exemple, les pistes métalliques 34, 36 sont en cuivre et les pistes métalliques 20, 29 sont en aluminium. Une couche isolante 46, appelée couche de passivation, recouvre les pistes métalliques 20, 29 et la couche isolante 40. Les couches 40, 46 sont en un même matériau isolant, par exemple de l'oxyde de silicium.

Le procédé de fabrication du circuit intégré 31 comprend une étape de recuit qui consiste, après la formation de la couche isolante 46 recouvrant les pistes métalliques 20, 29, à chauffer l'ensemble du circuit intégré 31 à une température, par exemple de l'ordre de quelques centaines de degrés, par exemple 400°C, pendant plusieurs dizaines de minutes, par exemple 50 minutes. L'étape de recuit entraîne un accroissement de la taille des grains métalliques des pistes métalliques, en particulier des grains métalliques dans les bras 16, 18 par diminution de la densité des joints de grains. Cet accroissement de la taille des grains entraîne l'apparition de contraintes de tension dans les grains métalliques des bras 16, 18. Ces contraintes de tension ne peuvent pas se relâcher en raison de la présence des couches isolantes 40, 46 qui entourent les bras 16, 18 et les forcent à conserver leurs formes initiales.

La figure 4 est une vue analogue à la figure 3 et illustre le principe d'une attaque par prise de contact. Une telle attaque comprend une étape initiale consistant à graver une ouverture 50 en surface du circuit intégré 31 là où l'on souhaite réaliser les prises de contact. L'ouverture 50 est réalisée par gravure de la couche isolante 46. Comme les couches isolantes 40 et 46 sont constituées du même matériau isolant, il n'est pas possible de contrôler avec précision la profondeur de l'ouverture 50. Si l'attaque est réalisée dans la région du circuit intégré 31 où se trouve l'interrupteur 10, par exemple, dans le but de doubler le chemin conducteur L, l'ouverture 50 va pénétrer au moins partiellement dans la couche isolante 40. Après réalisation de l'ouverture 50, la barre 20 est complètement dégagée et les bras 16 et 18 sont au moins partiellement dégagés.

Le retrait du matériau isolant entourant les bras 16, 18 se traduit par un relâchement des contraintes de tension dans les bras 16, 18, c'est-à-dire une diminution des longueurs L1 et L2. Comme les bras 16, 18 restent ancrés à une extrémité aux pistes 12, 14, leur raccourcissement entraîne un pivotement de la barre 20 autour du centre O, l'axe Δ3 restant sensiblement dans un plan perpendiculaire au plan P. Le pivotement de la barre 20 est suffisant pour qu'elle vienne au contact des pistes métalliques 29, 30.

La figure 5 est une vue de détail de la figure 2 qui représente l'état de l'interrupteur 10 après la gravure de l'ouverture 50. Les bras 16 et 18 n'étant pas dans le prolongement l'un de l'autre, leur raccourcissement a entraîné un pivotement de la barre 20. On peut observer également une légère déformation des bras 16, 18 par flambage. On appelle débattement D de la barre 20 la distance entre l'arête de l'extrémité 24 la plus proche du plan P' et le plan P' après libération des contraintes.

Le circuit de détection C relié aux pistes 29, 30 détecte la mise en contact de la barre 20 avec les pistes métalliques 29, 30. Ceci peut être interprété comme correspondant à une attaque par prise de contact et peut entraîner l'arrêt du fonctionnement du circuit intégré 31.

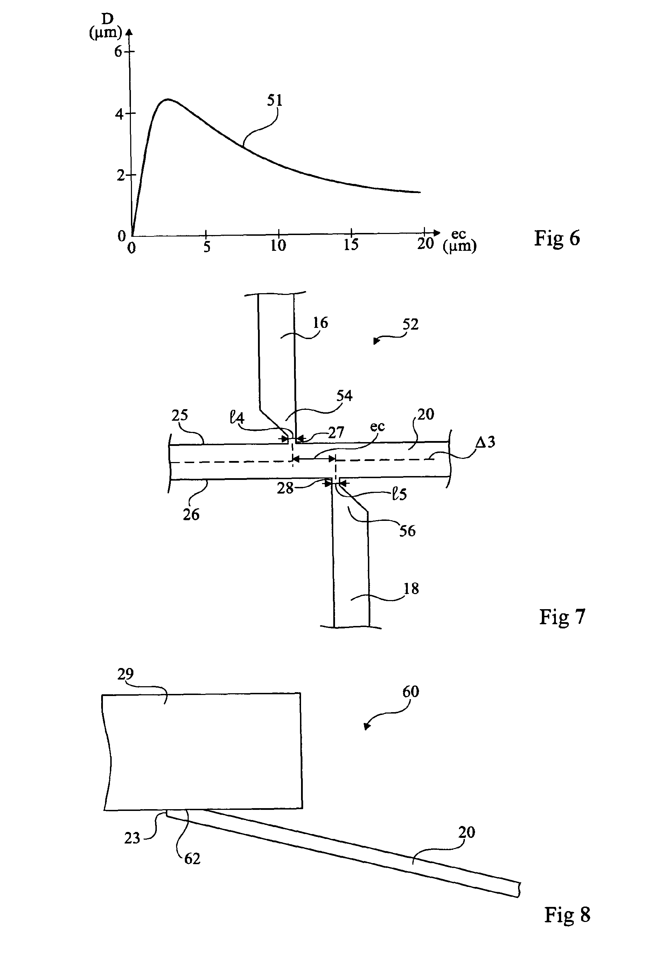

La figure 6 représente un exemple de courbe 51 d'évolution, en fonction de l'écartement ec, du débattement D que l'on observe en l'absence des pistes 29, 30. La courbe 51 est obtenue pour un interrupteur 10 pour lequel les longueurs L1, L2 et L3 sont égales à 100 µm, pour lequel les largeurs ℓ1, ℓ2, ℓ3 sont égales à 2 µm et pour lequel l'épaisseur des pistes métalliques du niveau de métallisation Ms est, par exemple, de l'ordre de 0,3 µm. Il est souhaitable que le débattement D de la barre 20 soit le plus important possible pour assurer qu'un contact sera toujours présent entre la barre 20 et les pistes métalliques 29, 30 en cas d'attaque. Dans l'exemple mentionné précédemment, un débattement D de l'ordre de 4,5 µm est obtenu pour un écartement ec de l'ordre de 4 µm.

Dans le présent exemple de réalisation, l'interrupteur 10 est réalisé au niveau d'un chemin conducteur L appartenant à un écran de protection. Les bras 16, 18 et la barre 20 relient électriquement les pistes 12, 14 entre elles. Les pistes 12 et 14 sont reliées à un circuit adapté à détecter une interruption du chemin conducteur L. Ceci offre une protection supplémentaire en plus de la protection conférée par l'interrupteur 10. Selon une variante de réalisation, seule la piste métallique 29 est présente. Dans ce cas, un circuit est adapté à détecter si un contact électrique est établi entre la piste métallique 29 et l'une des pistes 12 ou 14. Selon une autre variante, les pistes 29 et 30 peuvent correspondre à des plots métalliques. Ceci peut être avantageux lorsque plusieurs interrupteurs 10 sont disposés de façon adjacente.

La figure 7 représente une vue de détail d'un interrupteur 52 selon un autre exemple de réalisation de l'invention. L'interrupteur 52 a la même structure que l'interrupteur 10 à la différence que le bras 16 comprend, au niveau de l'extrémité reliée à la barre 20, une portion 54 dont la section diminue de sorte que la zone de jonction 27 a une section réduite, de largeur ℓ4, par rapport au bras 16. De façon analogue, le bras 18 comprend, au niveau de l'extrémité reliée à la barre 20, une portion 56 dont la section diminue de sorte que la zone de jonction 28 a une section réduite, de largeur ℓ5, par rapport au bras 18. Les zones de jonction 27, 28 de l'interrupteur 52 se déforment plus facilement lors du pivotement de la barre 20 que les zones de jonction 27, 28 de l'interrupteur 10 qui ont une section plus importante. Ceci permet pour un même écartement d'obtenir un débattement D plus important que lorsque les bras 16, 18 sont de section constante. A titre d'exemple, pour un interrupteur 52 pour lequel les longueurs L1, L2 et L3 sont égales à 100 µm, pour lequel les largeurs ℓ1, ℓ2, ℓ3 sont égales à 2 µm, pour lequel l'épaisseur des pistes métalliques du niveau de métallisation Ms est de l'ordre de 0,3 µm, et pour lequel les largeurs ℓ4 et ℓ5 sont de l'ordre de 0,2 µm, on obtient un débattement D, en l'absence des pistes 29, 30, de l'ordre de 10 µm pour un écartement ec de l'ordre de 4 µm.

De façon générale, la forme des zones de jonction 27, 28 est déterminée pour permettre l'obtention du plus grand débattement D possible de la barre 20 en l'absence des pistes 29, 30 tout en assurant une tenue mécanique suffisante de l'interrupteur 10. Selon un exemple, chaque zone de jonction 27, 28 peut avoir, dans un plan perpendiculaire au plan P, la forme d'un entonnoir. Selon un autre exemple, chaque zone de jonction 27, 28 peut comprendre des ouvertures traversantes.

La figure 8 représente un interrupteur 60 selon un autre exemple de réalisation de l'invention. L'interrupteur 60 comprend, à chaque extrémité 23 de la barre 20, une face biseautée 62 qui est orientée de sorte que, lors du pivotement de la barre 20, la face biseautée 62 vienne en appui contre la piste métallique 29. Ceci permet d'améliorer le contact entre la barre 20 et la piste métallique 29.

Dans les exemples de réalisation décrits précédemment, l'interrupteur 10, 52, 60 est constitué par des portions d'un matériau conducteur dans lequel apparaissent des contraintes de tension lors de l'étape de recuit du procédé de fabrication du circuit intégré. A titre de variante, l'interrupteur peut être constitué de portions d'un matériau conducteur dans lequel apparaissent des contraintes de compression lors de l'étape de recuit. Il s'agit, par exemple, d'un matériau semiconducteur tel que le silicium polycristallin. De ce fait, lors de la libération des contraintes, les bras 16, 18 de l'interrupteur tendent à s'allonger. Dans ce cas, par rapport à l'interrupteur 10 représenté en figure 2, le bras 16 est disposé à droite du plan P et le bras 18 est disposé à gauche du plan P de façon que la barre 20 pivote dans le bon sens lors de la libération des contraintes pour assurer la liaison électrique entre les pistes métalliques 29, 30.

Des modes de réalisation particuliers de la présente invention ont été décrits. Diverses variantes et modifications apparaîtront à l'homme de l'art. En particulier, dans les exemples de réalisation décrits précédemment, l'interrupteur 10 a une forme symétrique. Toutefois, ceci pourrait ne pas être le cas. En outre, dans les exemples de réalisation décrits précédemment, les bras 16, 18 et la barre 20 ont, avant pivotement, des formes rectilignes. Toutefois, les bras 16, 18 et la barre 20 pourraient avoir, avant pivotement, des formes courbes.

## Revendications

1. Circuit intégré (31) comprenant un dispositif (5) de détection d'attaque par intrusion, le dispositif comprenant :
une pièce monobloc constituée d'un matériau conducteur et entourée d'un matériau isolant (40, 46), **caractérisé en ce que** ladite pièce monobloc comprend :
au moins une piste conductrice allongée (16, 18), sous tension ou sous compression, et
un élément mobile conducteur (20) ; et que le dispositif comprend de plus
au moins une portion conductrice (29, 30) à distance de ladite pièce ; et
un circuit de détection (C) d'une liaison électrique entre ladite pièce et la portion conductrice (29,30),
d'où il résulte une variation de la longueur (L1, L2) de ladite piste conductrice (16,18) lors d'une attaque par retrait du matériau isolant, entraînant un déplacement de l'élément mobile conducteur (20) jusqu'à venir au contact de la portion conductrice (29,30).

2. Circuit intégré selon la revendication 1, dans lequel la pièce monobloc comprend :
une première barre (20) s'étendant selon une première direction (Δ₃) ;
une deuxième barre (16) s'étendant selon une deuxième direction (Δ₁) inclinée par rapport à la première direction et reliée à une première face latérale (25) de la première barre au niveau d'une première zone de jonction (27) ; et
une troisième barre (18) s'étendant selon une troisième direction (Δ₂) inclinée par rapport à la première direction et reliée à une seconde face latérale (26) de la première barre, opposée à la première face latérale, au niveau d'une seconde zone de jonction (28), les première et seconde zones de jonction étant décalées selon la première direction,
et dans lequel la au moins une portion conductrice (29, 30) est à distance des première, deuxième et troisième barres et disposée en vis-à-vis de la première ou seconde face latérale, d'où il résulte une variation de la longueur (L1, L2) des deuxième et troisième barres lors de l'attaque par retrait du matériau isolant, entraînant un pivotement de la première barre jusqu'à venir au contact de la portion conductrice.

3. Circuit selon la revendication 2, dans lequel la première barre (20) comprend des première et seconde extrémités (23, 24), dans lequel la portion conductrice (29) est disposée en vis-à-vis de la première face latérale (25), au niveau de la première extrémité, le circuit comprenant une portion conductrice (30) supplémentaire disposée en vis-à-vis de la seconde face latérale (26), à distance des première, deuxième et troisième barres (20, 16, 18), au niveau de la seconde extrémité, d'où il résulte une variation de la longueur (L1, L2) des deuxième et troisième barres lors de l'attaque par retrait du matériau isolant, entraînant un pivotement de la première barre de façon que la première extrémité vienne en contact avec la portion conductrice et que la seconde extrémité vienne en contact avec la portion conductrice supplémentaire.

4. Circuit selon la revendication 2 ou 3, dans lequel la deuxième barre (16) se prolonge par une première piste (12) du matériau conducteur de section plus importante et dans lequel la troisième barre (18) se prolonge par une seconde piste (14) du matériau conducteur de section plus importante.

5. Circuit selon l'une quelconque des revendications 2 à 4, dans lequel les deuxième et troisième barres (16, 18) appartiennent à un chemin conducteur (L).

6. Circuit selon l'une quelconque des revendications 2 à 5, dans lequel la section de la deuxième barre (16) diminue au niveau de la première zone de jonction (27) et dans lequel la section de la troisième barre (18) diminue au niveau de la seconde zone de jonction (28).

7. Circuit selon l'une quelconque des revendications 2 à 6, dans lequel la première barre (20) comprend une face biseautée (62) adaptée à venir en appui contre la portion conductrice (29) lors du pivotement de la première barre.

8. Circuit selon l'une quelconque des revendications 2 à 7, dans lequel les deuxième et troisième directions (Δ₁, Δ₂) sont parallèles entre elles et perpendiculaires à la première direction (Δ₁).

9. Procédé de fabrication d'un circuit intégré comprenant un dispositif (5) de détection d'attaque par intrusion, **caractérisé en ce qu'**il comprend les étapes suivantes :
former une pièce monobloc constituée d'un matériau conducteur et entourée d'un matériau isolant (40, 46), **caractérisé en ce que** ladite pièce monobloc comprend:
au moins une piste conductrice allongée (16, 18) et
un élément mobile, conducteur (20), au moins une portion conductrice (29, 30) à distance de ladite pièce et un circuit de détection (C) de l'établissement d'une liaison électrique entre ladite pièce et la portion conductrice (29,30); et **caractérisé par** l'étape de
faire un recuit,
d'où il résulte une apparition de contraintes de tension ou de compression dans ladite piste conductrice (16,18) et une variation de la longueur (L1, L2) de ladite piste conductrice (16,18) lors d'une attaque par retrait du matériau isolant, entraînant un déplacement de l'élément mobile conducteur (20) jusqu'à venir au contact de la portion conductrice (25,30).

## Claims

1. An integrated circuit (31) comprising an intrusion attack detection device (5), the device comprising:
a single-piece formed of a conductive material and surrounded with an insulating material (40, 46), **characterized in that** said single piece comprises:
at least one stretched or compressed elongated conductive track (16, 18), and
a conductive mobile element (20);
and **in that** the device further comprises:
at least one conductive portion (29, 30) distant from said piece; and
a circuit (C) for detecting an electric connection between said piece and the conductive portion (29, 30),
which results in a variation in the length (L1, L2) of said conductive track (16, 18) in an attack by removal of the insulating material, causing a displacement of the conductive mobile element (20) all the way until it contacts the conductive portion (29, 30).

2. The integrated circuit of claim 1, wherein the single-piece comprises:
a first bar (20) extending along a first direction (Δ₃);
a second bar (16) extending along a second direction (Δ₁) inclined with respect to the first direction and connected to a first lateral surface (25) of the first bar at the level of a first junction area (27); and
a third bar (18) extending along a third direction (Δ₂) inclined with respect to the first direction and connected to a second lateral surface (26) of the first bar, opposite to the first lateral surface, at the level of a second junction area (28), the first and second junction areas being shifted along the first direction,
and wherein said at least one conductive portion (29, 30) is distant from the first, second, and third bars and arranged opposite to the first or second lateral surface, which results in a variation in the length (L1, L2) of the second and third bars in the attack by removal of the insulating material, causing a pivoting of the first bar all the way until it contacts the conductive portion.

3. The circuit of claim 2, wherein the first bar (20) comprises first and second ends (23, 24), wherein the conductive portion (29) is arranged opposite to the first lateral surface (25), at the level of the first end, the circuit comprising an additional conductive portion (30) arranged opposite to the second lateral surface (26), distantly from the first, second, and third bars (20, 16, 18), at the level of the second end, which results in a variation of the length (L1, L2) of the second and third bars in the attack by removal of the insulating material, causing a pivoting of the first bar so that the first end comes into contact with the conductive portion and that the second end comes into contact with the additional conductive portion.

4. The circuit of claim 2 or 3, wherein the second bar (16) continues in a first track (12) of the conductive material of larger cross-section and wherein the third bar (18) continues in a second track (14) of the conductive material of larger cross-section.

5. The circuit of any of claims 2 to 4, wherein the second and third bars (16, 18) belong to a conductive path (L).

6. The circuit of any of claims 2 to 5, wherein the cross-section of the second bar (16) decreases at the level of the first junction area (27) and wherein the cross-section of the third bar (18) decreases at the level of the second junction area (28).

7. The circuit of any of claims 2 to 6, wherein the first bar (20) comprises a tapered surface (62) for bearing against the conductive portion (29) during the pivoting of the first bar.

8. The circuit of any of claims 2 to 7, wherein the second and third directions (Δ₁, Δ₂) are parallel to each other and perpendicular to the first direction (Δ₁).

9. A method for manufacturing an integrated circuit comprising a device (5) for detecting an intrusion attack, comprising the steps of:
forming a single-piece formed of a conductive material and surrounded with an insulating material (40, 46), **characterized in that** said single piece comprises at least one elongated conductive track (16, 18) and a conductive mobile element (20), at least one conductive portion (29, 30) distant from said piece and a circuit (C) for detecting the creation of an electric connection between said piece and the conductive portion (29, 30); and **characterized by** the step of
annealing,
which results in the creation of tensile or compressive stress in said conductive track (16, 18) and in a variation of the length (L1, L2) of said conductive track (16, 18) in an attack by removal of the insulating material, causing a displacement of the conductive mobile element (20) all the way until it contacts the conductive portion (29, 30).

## Patentansprüche

1. Eine integrierte Schaltung (31), die eine Eingriffs-Attacken-Detektionsvorrichtung (5) aufweist, wobei die Vorrichtung Folgendes aufweist:
ein Einzelteil geformt aus einem leitenden Material und umgeben mit einem Isoliermaterial (40, 46), **dadurch gekennzeichnet, dass** das Einzelteil Folgendes aufweist:
mindestens eine gestreckte oder zusammengedrückte langgestreckte leitende Bahn (16, 18), und
ein leitendes bewegliches Element (20);
wobei die Vorrichtung ferner Folgendes aufweist:
mindestens einen Leitungsteil (29, 30) entfernt gegenüber dem erwähnten Teil; und
eine Schaltung (C) zum Detektieren einer elektrischen Verbindung zwischen dem erwähnten Teil und dem Leitungsteil (29, 30), was eine Variation der Länge (L1, L2) der leitenden Bahn (16, 18) bei einem Angriff oder einer Attacke zur Folge hat und zwar durch Entfernen des Isoliermaterials, was eine Versetzung des leitenden beweglichen Elements (20) zur Folge hat und zwar über den ganzen Weg hinweg bis es den Leitungsteil (29, 30) kontaktiert.

2. Integrierte Schaltung nach Anspruch 1, wobei das Einzelteil Folgendes aufweist:
eine erste Stange (20), die sich entlang einer ersten Richtung (Δ₃) erstreckt;
eine zweite Stange (16), die sich entlang einer zweiten Richtung (Δ₁) erstreckt und zwar geneigt bezüglich der ersten Richtung und verbunden mit einer ersten seitlichen Oberfläche (25) der ersten Stange auf dem Niveau einer ersten Verbindungsfläche (27); und
eine dritte Stange (18), die sich entlang einer dritten Richtung (Δ₂) erstreckt und zwar geneigt bezüglich der ersten Richtung und zwar verbunden mit einer zweiten seitlichen Oberfläche (26) der ersten Stange,
entgegensetzt zur ersten seitlichen Oberfläche und zwar auf dem Niveau einer zweiten Verbindungsfläche (28), wobei die ersten und zweiten Verbindungsflächen entlang der ersten Richtung verschoben sind,
und wobei der mindestens eine Leitungsteil (29, 30) entfernt ist gegenüber den ersten, zweiten und dritten Stangen und angeordnet entgegengesetzt zu der ersten oder zweiten seitlichen Oberfläche, was eine Veränderung der Länge (L1, L2) der zweiten und dritten Stangen zur Folge hat und zwar in dem Angriff durch Entfernung des Isoliermaterials, was ein Verschwenken der ersten Stange den ganzen Weg bis zur Kontaktierung des Leitungsteils bewirkt.

3. Schaltung nach Anspruch 2, wobei die erste Stange (20) erste und zweite Enden (23, 24) aufweist, wobei der Leitungsteil (29) entgegengesetzt zu der ersten seitlichen Oberfläche (25) angeordnet ist und zwar auf dem Niveau des ersten Endes, wobei die Schaltung einen zusätzlichen Leitungsteil (30) aufweist und zwar angeordnet entgegengesetzt zu der zweiten seitlichen Oberfläche (26) entfernt von den ersten, zweiten und dritten Stangen (20, 16, 18) auf dem Niveau des zweiten Endes, was eine Veränderung oder Variation der Länge (L1, L2) der zweiten und dritten Stangen in dem Angriff zur Folge hat und zwar durch Entfernen des Isoliermaterials, was ein Verschwenken der ersten Stange derart bewirkt, dass das erste Ende in Kontakt mit dem Leitungsteil kommt, und dass das zweite Ende in Kontakt mit dem zusätzlichen Leitungsteil kommt.

4. Schaltung nach Anspruch 2 oder 3, wobei die zweite Stange (16) sich fortsetzt in einer ersten Bahn (12) des leitenden Materials des größeren Querschnitts und wobei die dritte Stange (18) sich fortsetzt in einer zweiten Bahn (14) des leitenden Materials des größeren Querschnitts.

5. Schaltung nach irgendeinem der Ansprüche 2 bis 4, wobei die zweiten und dritten Stangen (16, 18) zu einem leitenden Pfad (L) gehören.

6. Schaltung nach einem der Ansprüche 2 bis 5, wobei der Querschnitt der zweiten Stange (16) sich auf dem Niveau der ersten Verbindungsfläche (27) vermindert und wobei der Querschnitt der dritten Stange (18) sich auf dem Niveau der zweiten Verbindungsfläche (28) verringert.

7. Schaltung nach einem der Ansprüche 2 bis 6, wobei die erste Stange (20) eine verjüngte Oberfläche (62) aufweist und zwar zur Anlage an dem leitenden Teil (29) während des Schwenkens der ersten Stange.

8. Schaltung nach einem der Ansprüche 2 bis 7, wobei die zweiten und dritten Richtungen (Δ₁, Δ₂) parallel zueinander verlaufen und senkrecht zur ersten Richtung (Δ₁).

9. Ein Verfahren zur Herstellung einer integrierten Schaltung, wobei eine Vorrichtung (5) vorgesehen ist zum Detektieren einer Eingriffsattacke, wobei die folgenden Schritte vorgesehen sind:
Formen eines Einzelteils gebildet aus einem leitenden Material und
umgeben mit einem Isoliermaterial (40, 46), **dadurch gekennzeichnet,**
**dass** der erwähnte Einzelteil mindestens eine langgestreckte leitende Bahn (16, 18) aufweist und ein leitendes bewegliches Element (20),
wobei mindestens ein Leitungsteil (29, 30) entfernt gegenüber dem erwähnten Teil angeordnet ist und eine Schaltung (C) zum Detektieren der Erzeugung einer elektrischen Verbindung zwischen dem erwähnten Teil und dem Leitungsteil (29, 30); und **gekennzeichnet durch** den Schritt des Anlassens,
was die Schaffung von Zug- oder Kompressionsbeanspruchung in der leitenden Bahn (16, 18) zur Folge hat und eine Variation der Länge (L1, L2) der leitenden Bahn (16, 18) in einer Attacke **durch** Entfernung des Isoliermaterials, was eine Versetzung des leitenden beweglichen Elements (20) bewirkt und zwar über den ganzen Weg, bis dieses den Leitungsteil (29, 30) kontaktiert.
